# EUROPÄISCHE PATENTANMELDUNG

(11) **EP 4 815 034 A1**
(43) Veröffentlichungstag der Anmeldung: **30.09.2026**
(21) Anmeldenummer: 25166240.9
(22) Anmeldetag: 26.03.2025
(51) Int. Cl.: H01L 21/683, H01L 21/687

(54) **SUBSTRATHALTER FÜR EINE ELEKTROSTATISCHE SPANNVORRICHTUNG**

(71) Anmelder: Plansee SE, 6600 Reutte (AT)
(72) Erfinder: Schmidt, Hennrik, 6600 Reutte (AT); Knitel, Serafin, 6600 Reutte (AT); Wagner, Josef, 6600 Reutte (AT); Geiger, Sebastan, 6600 Reutte (AT)
(74) Vertreter: Ciesla, Dirk

(57) **Zusammenfassung**

Die vorliegende Erfindung betrifft einen Substrathalter (1) für eine elektrostatische Spannvorrichtung umfassend eine Keramikplatte (2) mit einer Keramikplattenoberseite (4) und einer Keramikplattenunterseite (5), wobei die Keramikplattenoberseite (4) ausgebildet ist, um ein Werkstück zu halten, und
eine Basisplatte (3) mit einer Basisplattenoberseite (6) und einer Basisplattenunterseite (7), wobei die Basisplattenoberseite zumindest abschnittsweise als Auflagefläche zur Verbindung mit der Keramikplattenunterseite ausgebildet ist, und die Auflagefläche eine Ebene ist, die am weitesten in Richtung der Keramikplatte hervorsteht, dadurch gekennzeichnet, dass die Basisplattenoberseite (6) im Bereich ihrer Auflagefläche vollflächig mit der Keramikplattenunterseite (5) über ein Lotmaterial (8) verbunden ist, und die Basisplatte aus einer Refraktärmetall-basierten Legierung hergestellt ist.

## Beschreibung

Die vorliegende Erfindung betrifft einen Substrathalter für eine elektrostatische Spannvorrichtung der aus einer Keramikplatte und einer Basisplatte aufgebaut ist, wobei die Basisplatte zumindest abschnittsweise als Auflagefläche zur Verbindung mit der Keramikplatte ausgebildet ist, und die Auflagefläche der Basisplatte vollflächig mit der Keramikplatte über ein Lotmaterial verbunden ist, und die Basisplatte aus einer Refraktärmetall-basierten Legierung gefertigt ist. Die vorliegende Erfindung betrifft ferner eine Verwendung des erfindungsgemäßen Substrathalters zum Halten und Bearbeiten von Halbleiter-Wafern, sowie eine elektrostatische Spannvorrichtung, welche den erfindungsgemäßen Substrathalter umfasst.

Eine elektrostatische Spannvorrichtung (auch als elektrostatisches Spannfutter oder E-Chuck bezeichnet) nutzt die Kraft der elektrostatischen Anziehung, um Werkstücke, wie beispielsweise Halbleiter-Wafer, auf einer keramischen Oberfläche während eines hochpräzisen Fertigungsprozesses sicher zu halten, zu fixieren, zu positionieren und/oder ggf. einzuebnen, und damit ihre Stabilität zu gewährleisten. Eine solche Spannvorrichtung besteht aus mehreren Komponenten, wie beispielsweise einer dielektrischen Schicht (wie z.B. Aluminiumoxid) und einer Elektrodenschicht (wie z.B. Molybdän, Kupfer oder Graphit), die zusammen ein elektrostatisches Feld erzeugen, um das Werkstück ohne mechanische Klammern oder Vakuumsauger auf einer keramischen Oberfläche zu fixieren. E-Chucks sind wichtige Komponenten, die in verschiedenen Branchen eingesetzt werden, von der Halbleiterproduktion bis zur Luft- und Raumfahrttechnik, wenn es um Präzision bei der Fertigung geht.

Die Patentanmeldung US 2021/0391153 beschreibt eine Substratverarbeitungsvorrichtung, die ebenfalls eine Plattform zum Tragen eines Substrats/Werkstücks umfasst. Hierbei liegt ein Fokus auf der Materialauswahl der Basis(platte) der Plattform, welche aus zwei Komponenten besteht. Eine Komponente hat einen niedrigen Ausdehnungskoeffizienten sowie eine hohe Wärmeleitfähigkeit, und die andere Komponente weist eine geringe Dichte auf. Die Basis(platte) besteht somit einerseits aus einem Material mit einer Dichte von 5,0 g/cm³ oder weniger (wie beispielsweise Al, Al-Legierung, Titan oder Titanlegierung) und andererseits aus einem Material mit einem niedrigen Ausdehnungskoeffizienten von 5,0 *10⁻⁶ 1/K oder weniger (wie beispielsweise Wolfram oder Molybdän).

Das Patent US 10,249,526 B2 beschreibt eine elektrostatische Spannvorrichtung aus einem keramischen Grundkörper mit einer Ober- und einer Unterseite, auf den eine Vielzahl von Objekten durch eine metallische Bindung, Löten oder durch andere Verbindungsmethoden an verschiedenen Stellen der Unterseite des Keramikkörpers angebracht ist. Dabei kann beispielsweise ein Objekt (z.B. ein Adapter) aus Molybdän gefertigt sein. Eine Basisplatte an der Unterseite des Keramikkörpers kann aus Aluminium oder Stahl gefertigt sein. Vorzugsweise ist auch noch eine Kühlplatte oder Isolatoren vorhanden.

Solche mehrschichtigen Strukturen können beispielsweise erhöhte Stabilität, verbesserte dielektrische Eigenschaften oder thermische Beständigkeit bieten, jedoch ist die Herstellung komplex (was auch zu erhöhten Kosten führt), die Wartung und Reparatur kann erschwert sein, und es können auch thermische und/oder mechanische Spannungen zwischen den Materialien auftreten.

Obwohl es bekannt ist den thermischen Ausdehnungskoeffizienten zwischen den verschiedenen Materialien, z.B. Refraktärmetall(en) und Keramik, anzupassen, ist es bis heute schwierig Substrathalter bereitzustellen, welche aus diesen Materialien aufgebaut sind und sowohl bei niedrigen (beispielsweise Temperaturen von -50°C) als auch bei hohen Prozesstemperaturen (beispielsweise Temperaturen über 400°C, max. 500°C) eingesetzt werden können, welche gegenüber thermischen Zyklen mit großen Temperaturschwankungen (z.B. Schwankungen zwischen -100°C und +40°C) beständig sind, und dabei geringe Spannungen in der Keramik zeigen bzw. ein Reißen der Keramik verhindern. Zudem sollte die Ausgasrate der verwendeten Materialien niedrig sein, so dass bei Vakuumanwendungen die Reinheit, die Produktionsqualität, sowie die Prozessstabilität nicht beeinträchtigt werden und somit die Leistung des E-Chucks negativ beeinflusst wird.

Die Aufgabe der vorliegenden Erfindung besteht darin, einen Substrathalter für eine elektrostatische Spannvorrichtung bereitzustellen, welcher keine Rissbildung in der Keramik aufweist und über eine große Temperaturspanne (-150°C oder weniger bis +500°C) eingesetzt werden kann. Gleichzeitig ist der erfindungsgemäße Substrathalter beständig gegenüber thermischen Zyklen mit großen Temperaturschwankungen. Der erfindungsgemäße Substrathalter weist in einfacher Weise eine feste Verbindung zwischen der Basisplatte und Keramikplatte über ein Lotmaterial auf, ohne dass die Keramikplatte nach dem Löten an die Basisplatte oder bei thermischer Belastung über ein großes Temperaturfenster oder bei abwechselnd thermischer Belastung Risse aufweist. Darüber hinaus weist der erfindungsgemäße Substrathalter eine niedrige Ausgasrate auf.

Die technische Aufgabe der vorliegenden Erfindung wird durch den Gegenstand von Anspruch 1 gelöst. Vorteilhafte Weiterbildungen der Erfindung sind den abhängigen Ansprüchen zu entnehmen, die untereinander frei kombinierbar sind.

Gemäß der vorliegenden Erfindung umfasst ein Substrathalter für eine elektrostatische Spannvorrichtung eine Keramikplatte mit einer Keramikplattenoberseite und einer Keramikplattenunterseite, wobei die Keramikplattenoberseite ausgebildet ist, um ein Werkstück zu halten, und eine Basisplatte mit einer Basisplattenoberseite und einer Basisplattenunterseite. Die Basisplattenoberseite ist zumindest abschnittsweise als Auflagefläche zur Verbindung mit der Keramikplattenunterseite ausgebildet. Die Auflagefläche ist dabei eine Ebene, die am weitesten in Richtung der Keramikplatte hervorsteht, d.h. wenn die Basisplatte mehrere Erhebungen oder Vertiefungen hat, ist die Auflagefläche diejenige Erhebung, die am weitesten nach oben ragt und somit die Verbindung zur Keramikplatte herstellt. Der Substrathalter ist dadurch gekennzeichnet, dass die Basisplattenoberseite im Bereich ihrer Auflagefläche vollflächig mit der Keramikplattenunterseite über ein Lotmaterial verbunden ist, und die Basisplatte aus einer Refraktärmetall-basierten Legierung hergestellt ist.

Somit wird ein Substrathalter zur Verfügung gestellt, der für die Anwendung in einer elektrostatischen Spannvorrichtung geeignet ist, eine bessere Wärmeleitfähigkeit sowie eine niedrige Ausgasrate aufweist, und über einen großen Temperaturbereich bzw. über eine große Temperaturspanne, d.h. sowohl bei niedrigen als auch bei höheren Temperaturen, oder starken zyklischen Temperaturschwankungen keine Rissbildung in der Keramik zeigt und somit eine hohe Temperaturbeständigkeit aufweist.

Unter einer Keramik ist eine Klasse von anorganischen, nichtmetallischen Werkstoffen zu verstehen, welche typischerweise eine hohe Hitzebeständigkeit, eine geringe Ausgasrate, eine hohe mechanische Festigkeit sowie eine gleichmäßige Haltekraft ermöglichen. Sie sind von Natur aus spröde. Die Keramik fungiert im erfindungsgemäßen Substrathalter als eine dielektrische Komponente, so dass sie als elektrischer Isolator dient und in Kombination mit anderen Materialien zur Speicherung elektrischer Energie beitragen kann.

In einer erfindungsgemäßen Weiterbildung ist die Keramikplatte frei von eingebauten Elementen, d.h. in der Keramikplatte sind keine zusätzlichen Komponenten oder Teile eingebaut. Eingebaute Elemente/Komponenten können z.B. Kühlelemente, Heizelemente, Elektrodenfilme etc. sein. Wie bereits oben ausgeführt ist die Keramik von Natur aus spröde und anfällig für Brüche und Risse, so dass ein solcher Einbau ein komplexes Verfahren erfordert. Darüber hinaus kann der Einbau solcher Elemente in die Keramikplatte hohe Kosten verursachen.

In einer weiteren Ausführungsform ist der erfindungsgemäße Substrathalter dadurch gekennzeichnet, dass die Keramikplattenoberseite freiliegend ist und nicht durch andere/weitere Materialien oder Schichten bedeckt ist oder geschützt wird. Dadurch ist die Keramikplatte direkt mit der Umgebung oder dem Werkstück in Kontakt. Dies hat beispielsweise den Vorteil einer besseren Wärmeableitung sowie einer direkten elektrostatischen Haftung.

Das Lotmaterial dient dazu, die Basisplattenoberseite im Bereich ihrer Auflagefläche mit der Keramikplattenunterseite stoffschlüssig zu verbinden, so dass die Keramikplatte mit der Basisplatte unlösbar und dauerhaft verbunden ist. Dadurch ergibt sich eine hohe Festigkeit der Verbindung, eine hohe Übertragbarkeit von Kräften, sowie eine hohe Dichtigkeit.

In einer bevorzugten Ausführungsform ist das Lotmaterial ein Aktivlot, welches geeignet ist um nichtmetallische Werkstoffe (wie Keramik) mit metallischen Werkstoffen zu verbinden. Dadurch ist ein direktes Löten der Keramik ohne Aufbringen einer zusätzlichen Metallisierung möglich. Bei den Aktivloten handelt es sich um metallische Lote, die aufgrund ihrer Legierungszusammensetzung in der Lage sind, nichtmetallische Werkstoffe zu benetzen. Sie basieren beispielsweise auf Silber, Kupfer, Titan, Zirkonium oder Hafnium, die mit der Keramikplatte reagieren.

In einer bevorzugten Ausführungsform ist das Lotmaterial ein Silber-, Kupfer-, Titan- oder Zirkonium-basiertes Aktivlot. Insbesondere werden Aktivlote aus Titan/Silber, Indium/Kupfer/Silber, Silber/Kupfer/Indium/Titan, oder Titan/Kupfer/Silber verwendet. Das Löten erfolgt beispielsweise unter Schutzgasatmosphäre (z.B. Argon, Stickstoff oder Gemische davon), unter Wasserstoff-Atmosphäre, oder im Vakuum.

Das Aktivlot kann bei Raumtemperatur als Folie, als Paste, oder in Pulverform, insbesondere auch über Kaltgasspritzen (CGS = cold gas spraying), auf die Basisplatte und/oder die Keramikplatte aufgebracht werden. Wird eine Lötfolie verwendet, kann diese Lötfolie eine Dicke zwischen 10 und 300 µm aufweisen.

In einer bevorzugten Ausführungsform wird das Aktivlot auf eine gleichmäßige, glatte Oberfläche bzw. Auflagefläche der Basisplatte, welche zuvor standardmäßig geschliffen wurde, aufgebracht. Dies bedeutet, dass noch kleine Vertiefungen und/oder Spitzen an der Oberfläche bzw. Auflagefläche der Basisplatte vorhanden sein können.

Zwischen der Basisplattenoberseite und der Keramikplattenunterseite bildet sich ein Lotspalt. Dieser Lotspalt kann in einer bevorzugten Ausführungsform zwischen 30 und 200 µm, bevorzugt zwischen 40 und 100 µm, betragen. Im Bereich dieser Dicken ist die Qualität und Haltbarkeit der Lötverbindung verbessert.

Die Auflagefläche der Basisplattenoberseite ist die spezifische Fläche, auf welcher die Keramikplatte mit der Keramikplattenunterseite aufliegt. Dabei ist die Auflagefläche eine Ebene, die am weitesten in Richtung der Keramikplatte bzw. Keramikplattenunterseite vorsteht. Wenn beispielsweise die Basisplatte an ihrer Oberseite Vertiefungen oder Bohrungen aufweist, kann die Auflagefläche nur 50% der Gesamtgrundfläche der Basisplatte betragen. Die Auflagefläche ist bevorzugt mindestens 70%, bevorzugt mindestens 90% der Gesamtgrundfläche der Basisplatte. Eine größere Auflagefläche sorgt für eine bessere Stabilität.

In einer bevorzugten Ausführungsform ist die gesamte bzw. die annähernd gesamte Basisplattenoberseite als Auflagefläche ausgebildet, d.h. die Auflagefläche beträgt mindestens 99% der Gesamtgrundfläche der Basisplatte. Dabei weist die Basisplatte keine Erhöhungen oder Vertiefungen auf, kann aber noch kleinere Bohrungen haben.

Der Begriff "vollflächig verbunden" bedeutet, dass die Basisplattenoberseite im Bereich ihrer Auflagefläche mit der Keramikplattenunterseite über das Lotmaterial kontinuierlich und insbesondere ohne Unterbrechungen oder Lücken im Lotmaterial verbunden sind. Darüber hinaus ist das Lotmaterial flächendeckend und gleichmäßig über die Auflagefläche aufgetragen. Die Lotschicht ist im Bereich der Auflagefläche/Verbindungsfläche (welche Keramikplattenunterseite und Basisplattenoberseite miteinander verbindet) vorzugsweise zu mindestens 92%, bevorzugt zu 95%, besonders bevorzugt zu 100%, verbunden. Dies kann beispielsweise mit einer Ultraschall-Untersuchung (C-Scan) nachgewiesen werden. Dies gewährleistet eine nahezu vollständige bzw. vollständige, stoffschlüssige und gleichmäßige Verbindung im Bereich der Auflagefläche, die sowohl mechanische Stabilität als auch thermische und elektrische Leitfähigkeit sicherstellt. Darüber hinaus wird die Belastung auf die Keramik (bei hohen Temperaturen oder thermischen Zyklen) gleichmäßig über die gesamte Auflagefläche verteilt, was besonders wichtig ist, um Materialermüdung zu minimieren und somit die Lebensdauer zu verlängern.

Die Basisplatte des Substrathalters ist aus einer Refraktärmetall-basierenden Legierung hergestellt. Unter Refraktärmetall-basierenden Legierungen versteht man Legierungen mit ≥ 50 Gew.%, bevorzugt ≥ 65 Gew.% eines Refraktärmetalls ausgewählt aus der Gruppe der 4., 5. und 6. Nebengruppe des Periodensystems. Insbesondere werden Molybdän (Mo) und Wolfram (W) verwendet. So wird beispielsweise unter einer Molybdän-basierten Legierung verstanden, dass die Legierung einen Mo-Gehalt von ≥ 50 Gew.% Mo, insbesondere ≥ 65 Gew.% Mo, aufweist. Dasselbe gilt für eine Wolfram-basierte Legierung. In einer weiteren Ausführungsform kann die Refraktärmetall-basierende Legierung auch ≥ 80 Gew.% des jeweiligen Refraktärmetalls aufweisen. Vorzugsweise hat die Refraktärmetall-basierende Legierung einen Refraktärmetall-Gehalt zwischen >50 Gew.% und ≤99,7 Gew.% des jeweiligen Refraktärmetalls.

In einer bevorzugten Ausführungsform ist die Refraktärmetall-basierte Legierung Molybdänlegierung eine Mo-Titan (Ti)-Legierung mit 25-38 Gew.%, bevorzugt 32-35 Gew.% Ti, Rest Molybdän und unvermeidbare Verunreinigungen.

Die Basisplatte weist bevorzugt eine Dichte von mehr als 97% der relativen Dichte auf. Besonders vorteilhaft ist eine Dichte von mehr als 98% der relativen Dichte. Ist die Basisplatte aus einer Mo-Ti Legierung weist diese beispielsweise eine Dichte von mehr als 7 g/cm³, bevorzugt mehr als 7,24 g/cm³ (d.h. >99% der relativen Dichte), auf.

Die relative Dichte kann z.B. aus einem Schliffbild der Basisplatte ermittelt werden. Dabei wird die Mikrostruktur der Verbindung analysiert, wobei die relative Dichte das Verhältnis der gemessenen Dichte zur Dichte eines idealen, porenfreien Materials angibt.

Gemäß einer Weiterbildung weist die Refraktärmetall-basierte Legierung einen linearen Wärmeausdehnungskoeffizienten (engl.: Coefficient of Thermal Expansion = CTE) von über 5,5*10⁻⁶ 1/K bei Raumtemperatur auf. Der maximale CTE beträgt 9*10⁻⁶ 1/K. Der lineare Wärmeausdehnungskoeffizient ist stoffspezifisch und temperaturabhängig. Er gibt an wie sich die Refraktärmetall-Legierung bei bestimmten Temperaturen in ihren Abmessungen verändert. Um rissfreie Verbindungsresultate zwischen der Basisplatte und der Keramikplatte zu erreichen, ist es wichtig, dass der CTE-Wert beider Materialien über ein großes Temperaturfenster identisch oder nur leicht unterschiedlich ist. Dies bedeutet, dass der lineare Wärmeausdehnungskoeffizient (CTE) der Keramikplatte in dieser Ausführungsform einen ähnlichen Wert aufweist. Dadurch können thermische Spannungen und mögliche Risse vermieden werden.

In einer bevorzugten Ausführungsform ist die Keramik eine oxidische oder nitridische Keramik oder eine Carbidkeramik. Beispielsweise können Al₂O₃ (Aluminiumoxid), ZrO₂ Zirkonoxid), YSZ (Yttrium stabilisiertes Zirkonoxid), Si₃N₄ (Siliziumnitrid) AlN (Aluminiumnitrid) oder SiC (Siliziumcarbid) verwendet werden. Ebenfalls eignen sich keramische Verbundwerkstoffe (die aus einer keramischen Matrix bestehen, die mit keramischen Fasern oder Partikeln verstärkt sind). Bei keramischen Verbundstoffen können die mechanischen und thermischen Eigenschaften des Materials verbessert sein, so dass es widerstandfähiger und vielseitiger als herkömmliche Keramiken ist.

In der vorliegenden Erfindung wird das Werkstück, beispielsweise ein Halbleiter-Wafer, auf der Oberseite der Keramikplatte platziert.

In einer bevorzugten Ausführungsform ist die Basisplatte aus mindestens zwei Platten aufgebaut, welche beide aus Refraktärmetall-basierenden Legierung bestehen. Die Basisplatte kann jedoch auch drei, vier oder mehr Platten aufweisen. Dabei kann jede einzelne Platte in diesem Verbund aus unterschiedliche oder identische Refraktärmetall-basierende Legierungen gefertigt sein. Die Platten sind durch Diffusionsschweißen verbunden. Wenn es sich um zwei Platten aus identischen Refraktärmetall-basierende Legierungen handelt, weist die Fügezone bzw. Verbindungszone der verschweißte Basisplatten die gleichen physikalischen und mechanischen Eigenschaften wie die Basisplatte auf. In einer bevorzugten Ausführungsform sind zumindest zwei Platten der Basisplatte aus derselben Refraktärmetall-basierenden Legierung hergestellt. Diffusionsschweißen ist eine Schweißtechnik, welche das Verbinden der beiden Refraktämetall-basierten Platten ohne Einsatz von Zusatzwerkstoffen ermöglicht. Dadurch lassen sich beispielsweise innenliegende Strukturen (Geometrien) an der Basisplatte realisieren. Wenn Platten aus demselben Materialtyp vorliegen, ergeben sich gleiche Eigenschaften über die Gesamtheit der Basisplatte. So können beispielsweise auf einfache Weise innenliegende Kühlkanäle in der Basisplatte realisiert werden. Dafür wird vor dem Diffusionsschweißen mindestens eine Platte mit Vertiefungen/Erhöhungen versehen, so dass sich beim Verbinden mit der zweiten Platte innenliegende Kanäle ergeben. Es ist jedoch auch möglich, dass beide Platten Vertiefungen und/oder Erhöhungen aufweisen. Hier ergeben sich ebenfalls innenliegende Strukturen beim Verschweißen der Platten. Die innenliegenden Strukturen können beispielsweise eine Temperaturkontrolle über die gesamte Fläche des Substrathalters ermöglichen. Darüber hinaus ist es möglich, dass eine oder mehrere Platte(n) Bohrungen aufweist, welche beispielsweise als Positionierungspins für das Diffusionsschweißen dienen können. Durch solche Positionierungspins bleiben die Platten in der richtigen Position, während sie unter Druck und hoher Temperatur diffusionsverschweißt werden. Darüber hinaus können solche Bohrungen z.B. auch als Gas- oder Flüssigkeitszuleitung genutzt werden. Welche der oben angeführten Platten, die wahlweise Bohrungen und/oder Vertiefungen und/oder Erhöhungen zeigen, anschließend mit der Keramikplatte verlötet wird, ist anwendungsabhängig.

In einer weiteren Ausführungsform weist eine Platte Vertiefungen auf und eine zweite Platte weist Bohrungen auf, welche über den Vertiefungen platziert sind. Dadurch ist es möglich, dass beispielsweise Kühlkanäle direkt an die Basisplattenoberseite grenzen und eine effektive Kühlung der Keramik nach der Verlötung des Basisplattenoberseite und der Keramikplattenunterseite ermöglichen.

Beim Diffusionsschweißen ist es entscheidend, dass die Oberflächen, welche verschweißt werden, so plan und glatt wie möglich sind, um einen innigen Kontakt zwischen den zu verschweißenden Oberflächen zu gewährleisten, so dass der Kontakt die Diffusion der Atome über die Fügezone bzw. Verbindungszone hin ermöglicht.

Die Basisplatte bzw. die zumindest zwei Platten der Basisplatte der vorliegenden Erfindung sind vorzugsweise pulvermetallurgisch über Pressen, Sintern und/oder Heißisostatisches Pressen hergestellt. Das kann einfach über das Mikrogefüge der Basisplatte festgestellt werden, da unmittelbar nach dem Sintern die Mikrostruktur feinkörnig ist. Durch die pulvermetallurgische Herstellung können komplexe Geometrien mit einem minimale Materialverlust hergestellt werden, welche eine homogene Zusammensetzung sowie eine kontrollierte Porosität und Dichte aufweisen.

Insbesondere wird der erfindungsgemäße Substrathalter zum Halten und Bearbeiten eines Halbleiter-Wafers verwendet. Ein Halbleiter-Wafer ist eine dünne Scheibe aus einem Halbleitermaterial, wie Silizium, die als Grundlage für die Herstellung von integrierten Schaltkreisen und anderen Mikroelektronikteilen dient. Die Halbleiter-Wafer werden auch für Solarzellen oder Sensoren verwendet. Die Verwendung der erfindungsgemäßen Substrathalters ermöglicht einen sicheren Transport zwischen verschiedenen Prozessstationen (ohne Beschädigung des Wafers), eine stabile und präzise Positionierung des Wafers während der Bearbeitung (was die Genauigkeit und Qualität der hergestellten Wafer verbessert), sowie eine effiziente Prozessführung.

Die vorliegende Erfindung betrifft ferner eine elektrostatische Spannvorrichtung, welche den erfindungsgemäßen Substrathalter, Elektrode(n), eine Spannungsquelle und eine Steuereinheit umfasst.

Die Elektrode(n) ist/sind so an bzw. in der Nähe der Keramikplatte angebracht, dass nach Anlegen einer elektrischen Spannung ein elektrisches Feld erzeugt wird. Dieses elektrische Feld bewirkt eine elektrostatische Anziehungskraft zwischen dem Substrathalter und dem darauf platzierten Werkstück.

Die Spannungsquelle legt eine elektrische Spannung an die Elektroden und sorgt dafür, dass das elektrische Feld stabil und gleichmäßig bliebt.

Die Steuereinheit regelt die angelegte Spannung und somit die Stärke der elektrostatischen Anziehung. Dadurch ist es möglich die Einstellung der Spannkraft präzise zu kontrollieren

In einer bevorzugten Ausführungsform der Spannvorrichtung weist die Basisplatte eine Kühlvorrichtung auf. Dadurch kann die Temperatur in der Spannvorrichtung kontrolliert werden und eine Überhitzung der einzelnen Komponenten verhindert werden. Durch die effektive Ableitung von Wärme kann beispielsweise eine homogenen Temperaturverteilung über den gesamten Substrathalter erreicht werden. Durch ein gut funktionierende Kühlsystem kann die Spannvorrichtung unter konstanten Bedingungen arbeiten, was die Präzision und Stabilität der Bearbeitung verbessert. Darüber hinaus kann durch eine effektive Kühlung die Lebensdauer der Spannvorrichtung verlängert werden, weil die thermische Belastung auf die einzelnen Komponenten reduziert ist.

Weitere Vorteile und Zweckmäßigkeiten der Erfindung ergeben sich anhand der nachfolgenden Beschreibung von einem erfindungsgemäßen und einem nicht-erfindungsgemäßen Ausführungsbeispiel unter Bezugnahme auf die beigefügten Figuren.

Von den Figuren zeigen
- Fig. 1:: schematischer Querschnitt eines Substrathalters gemäß der vorliegenden Erfindung;
- Fig. 2:: Oberseite(n) der Keramikplatte(n) in den erfindungsgemäßen Beispielen;
- Fig. 3: Diagramm-Darstellung der relative Längenänderung ΔL/L₀ einer Basisplatte (MoTi) und einer Keramikplatte (Al₂O₃) bei verschiedenen Temperaturen;
- Fig. 4: Oberseite(n) der Keramikplatte(n) in den Vergleichsbeispielen;
- Fig. 5: schematischer Querschnitt eines Substrathalters gemäß einer weiteren Ausführungsform der vorliegenden Erfindung;
- Fig. 6: Mikrostruktur einer erfindungsgemäßen diffusionsgeschweißten Basisplatte (MoTi-MoTi) in einer lichtmikroskopischen Aufnahme bei einer 100-fachen Vergrößerung.
- Fig. 7: zeigt einen Querschnitt eines Substrathalters gemäß der vorliegenden Erfindung in einer lichtmikroskopischen Aufnahme bei einer 500-fachen Vergrößerung.

Die Erfindung wird nachfolgend durch Produktionsbeispiele und die beigefügten Figuren näher erläutert:

### Beispiele (gemäß der Erfindung):

In einem ersten Schritt wird ein Mo-Pulver mit einer Partikelgröße von ca. 4,5-5 µm (Messung gemäß Fisher Sub-Sieve Sizer) mit einem Ti-Pulver mit einer durchschnittlichen Partikelgröße von <160 µm im Verhältnis 31 Gew.% Ti, 69 Gew.% Mo gemischt, bis ein homogener Mischgrad erreicht ist. Im Anschluss wird das Pulvergemisch in eine Schlauchpressform eingefüllt und mit einem Druck von ca. 160 MPa kalt-isostatisch gepresst. Der scheibenförmige Grünkörper wird anschließend bei 1000°C und einem Druck von 100 MPa zu einer Basisplatte (Platte) mit einem Durchmesser von ca. 380 mm heiß isostatisch gepresst (geHIPt - HIP= hot isostatic pressing).

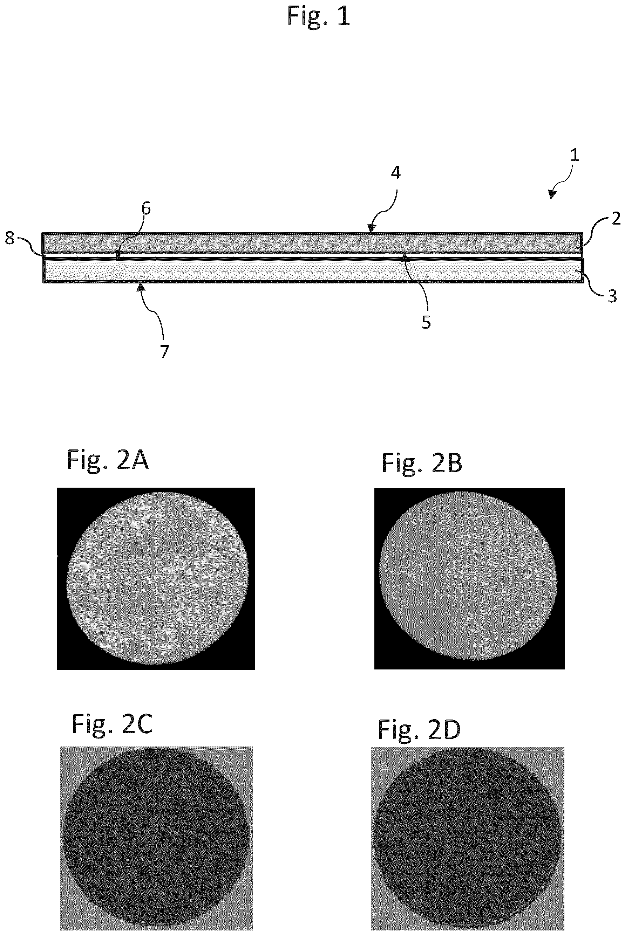

Die Basisplatte weist nach diesem Schritt eine relative Dichte von > 97% auf. Anschließend wird in einem ersten Beispiel die Basisplatte per Lötung mit einer ca. 4 mm dicken Al₂O₃-Keramik mit einem Reinheitsgrad von 96% verbunden. In einem weiteren Beispiel wird die Basisplatte mit einer ca. 4 mm dicken Al₂O₃-Keramik mit einem Reinheitsgrad von 99,99% verbunden. Das verwendete Lot ist bei beiden Beispielen ein Ag-basiertes Aktivlot (beispielsweise Ticusil^{®} oder Incusil^{®} von Morgan Advanced Materials). Das Lot wird in beiden Fällen als Lötfolie mit einer Dicke von 100 µm aufgebracht. Die Lötung erfolgte jeweils flächendeckend bei einer Temperatur zwischen 750 und 950°C und einer Haltezeit zwischen 15 und 30 Minuten. Fig. 1 zeigt schematisch den Querschnitt des erfindungsgemäßen Substrathalters (1). Die Keramikplatte (2) weist eine Keramikplattenoberseite (4) und eine Keramikplattenunterseite (5) auf, wobei die Keramikplattenoberseite (4) als Haltefläche für ein Werkstück (z.B. Silizium-Wafer) ausgebildet ist. Die Basisplatte (3) weist eine Basisplattenoberseite (6) und eine Basisplattenunterseite (7) auf. Über ein Lotmaterial (8) wird die Basisplattenoberseite (6) mit der Keramikplattenunterseite (5) vollflächig verbunden, um den erfindungsgemäßen Substrathalter zu erhalten.

Die Figuren 2A und 2B zeigen die jeweilige Keramikplattenoberseite der erfindungsgemäßen Substrathalter direkt nach dem Löten. Fig. 2A: erfindungsgemäßer Substrathalter nach Farbeindringprüfung, wobei die Keramik eine Reinheit von 96% aufweist; Fig. 2B: erfindungsgemäßer Substrathalter nach Farbeindringprüfung, bei dem die Keramik eine Reinheit von 99,99% aufweist. Zur besseren Sichtbarmachung eventueller Unregelmäßigkeiten, z.B. Risse oder Defekte, in der Keramikplatte wurde eine Farbeindringprüfung (auch Dye-Test oder Dye Penetration Test) durchgeführt. Dabei wird auf die Oberfläche des Substrathalters (d.h. auf die Keramikplatte) ein flüssiges Farbeindringmittel aufgetragen, das eine gewisse Zeit einwirkt. Danach wird das überschüssige Farbeindringmittel entfernt und ein Entwickler aufgetragen, der die Risse oder Defekte sichtbar macht. Die Bilder der Figuren 2A und 2B wurden unter UV-Licht aufgenommen.

Figur 2C zeigt die Verbindungsqualität, d.h. die Anbindung der Keramikplatte an die Basisplatte, bei einer Keramik mit 96% Reinheit und Figur 2D zeigt die Verbindungsqualität bei einer Keramik mit 99,99% Reinheit. Beide Figuren wurden über einen C-Scan bzw. Kontur-Scan (Ultraschallprüfung) erhalten, ohne dass für diese Prüfung der Substrathalter zerstört werden muss. Bei dieser Ultraschallprüfung erfolgt die Bildgebung durch das Senden und Empfangen von Ultraschallimpulsen, wobei reflektierte Echos analysiert und in ein Bild umgewandelt werden (hier Verbindung Keramikplatte- Basisplatte). Dadurch kann man Rückschlüsse auf die Qualität und Integrität der Lötverbindung ziehen. Wird kein Signal (0%) bis wenig Signal reflektiert spricht man von einer guten Anbindung. Die Figuren 2C und 2D zeigen die Ergebnisse dieser Prüfung. Bei beiden Proben konnten keine Defekte bei der Anbindung zwischen Keramikplatte und Basisplatte detektiert werden, d.h. es liegt eine vollflächige und homogene Verbindung zwischen Keramikplatte und Basisplatte vor.

Zusammenfassend zeigen die erfindungsgemäßen Substrathalter eine rissfreie Oberfläche der Keramik nach dem Löten. Die Anbindung der Keramik an die Basisplatte nach dem Löten ist homogen und per Ultraschall defektfrei. Die erfindungsgemäßen Substrathalter weisen sowohl eine geforderte Gasdichtheit als auch eine gute Wärmeleitfähigkeit auf. Gleichzeitig zeigen sie eine gute Beständigkeit gegenüber thermischen Zyklen und hohen Prozesstemperaturen.

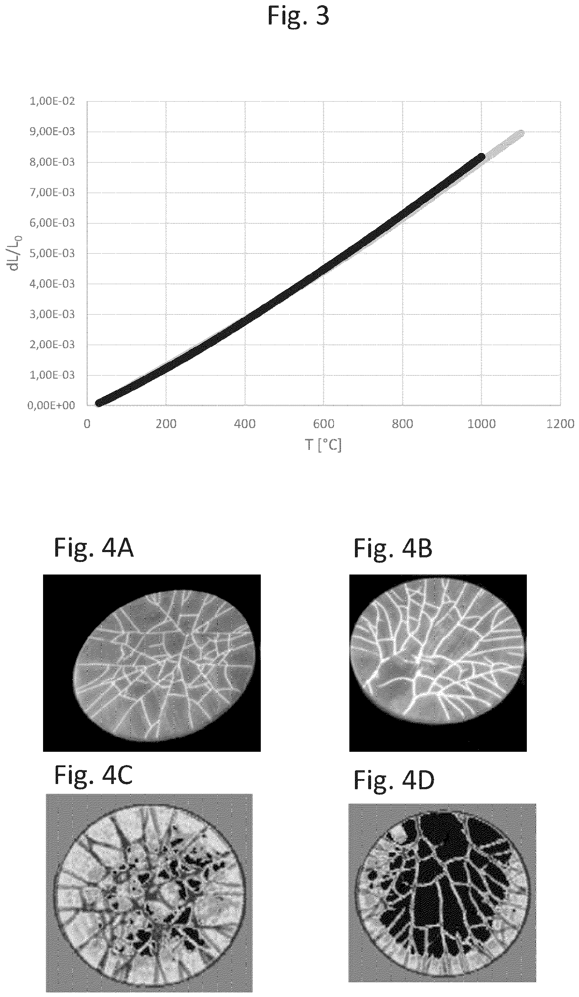

Fig. 3 zeigt exemplarisch die relative Längenänderung dL/L₀ einer nicht verlöteten MoTi-Platte (graue Linie) und einer nicht verlöteten Al₂O₃-Platte (schwarze Linie) bei verschiedenen Temperaturen. Dabei ist L₀ die ursprüngliche Länge und dL die Längenänderung des Materials aufgrund der Temperaturänderung. Das Diagramm zeigt, dass die relative Längenänderung der beiden Materialien zwischen Raumtemperatur und einer Temperatur von 1000°C weitestgehend identisch ist.

### Vergleichsbeispiele:

Im Vergleichsbeispiel wurde die Basisplatte aus einem reinen Refraktärmetall, hier einem Mo-Pulver mit einer Partikelgröße von ca. 4,5-5 µm (Messung gemäß Fisher Sub-Sieve Sizer), hergestellt. Das Mo-Pulver weist einen Gehalt von 99,97 Gew.% Mo auf, Rest unvermeidbare Verunreinigungen. Das Pulver wird in eine Schlauchpressform eingefüllt und mit einem Druck von ca. 160 MPa kalt-isostatisch gepresst. Der quaderförmige Grünkörper wird anschließend bei 2000°C gesintert und danach zu einer Platte gewalzt. Nachfolgend wird aus der gewalzten Platte eine runde Basisplatte mit einem Durchmesser von ca. 380 mm ausgeschnitten. Die Basisplatte weist nach diesem Schritt eine relative Dichte von > 99,9% auf. Anschließend wird in einem ersten Vergleichsbeispiel die Basisplatte per Lötung mit einer ca. 4 mm dicken Al₂O₃-Keramik mit einem Reinheitsgrad von 96% verbunden. In einem weiteren Vergleichsbeispiel wird die Basisplatte mit einer ca. 4 mm dicken Al₂O₃-Keramik mit einem Reinheitsgrad von 99,6% verbunden. Das verwendete Lot ist hierbei ein Ag-basiertes Aktivlot (beispielsweise Ticusil^{®} oder Incusil^{®} von Morgan Advanced Materials). Das Lot wird in beiden Fällen als Folie mit einer Dicke von 100 µm aufgetragen. Die Lötung erfolgte jeweils flächendeckend.

Die Figuren 4A und 4B zeigen die Oberfläche der Keramikplatte der Substrathalter, welche nicht erfindungsgemäß sind, direkt nach dem Löten. Fig. 4A: nicht-erfindungsgemäßer Substrathalter nach Farbeindringprüfung, wobei die Keramik eine Reinheit von 96% aufweist; Fig. 4B: nicht-erfindungsgemäßer Substrathalter Farbeindringprüfung, bei dem die Keramik eine Reinheit von 99,6% aufweist. Zur besseren Sichtbarmachung eventueller Unregelmäßigkeiten, z.B. Risse oder Defekte, in der Keramikplatte wurde Farbeindringprüfung (auch Dye-Test oder Dye Penetration Test) durchgeführt. Dabei wird auf die Oberfläche (Keramikplatte) des Substrathalters ein flüssiges Farbeindringmittel aufgetragen, das eine gewisse Zeit einwirkt. Danach wird das überschüssige Farbeindringmittel entfernt und ein Entwickler aufgetragen, der die Risse oder Defekte sichtbar macht. Die beiden oberen Bilder wurden unter UV-Licht aufgenommen.

Die Figur 4C zeigt die Verbindungsqualität, d.h. die Anbindung der Keramikplatte an die Basisplatte, bei einer Keramik mit 96% Reinheit. Hier wurde wie bereits oben (im erfindungsgemäßen Beispiel) erwähnt ein C-Scan (Ultraschallprüfung) durchgeführt. In Fig. 4C ist zu erkennen, dass der größte Teil der Verbindungsfläche zu ca. 40-50% reflektiert (siehe hellgraue Stellen) wird und einige Anteile der Verbindungsfläche sogar zu 100% reflektiert werden (siehe dunkle Stellen). Das entspricht einer mittleren Anbindung mit einigen Stellen, welche bereits eine schlechte Anbindung aufweisen. Fig. 4D zeigt die Verbindungsqualität bei einer Keramik mit 99,6% Reinheit. Im C-Scan wird der größte Teil der Verbindungsfläche zu 100% reflektiert (siehe dunkle Stellen). Nur noch wenige Anteile der Verbindungsfläche werden ca. 40-50% reflektiert (siehe hellgraue Stellen). Das entspricht einer eher schlechten Anbindung an die Keramikplatte. In Fig. 4C und 4D streuen die Risse die Ultraschallimpulse und folglich kann die Anbindung im Bereich der Risse nicht beurteilt werden.

In Fig. 4A und 4B sind deutlich Risse in der Oberfläche der Keramik nach dem Löten zu erkennen. Die Anbindung der Keramik an die Basisplatte nach dem flächendeckenden Verlöten ist mittel bis schlecht.

Es zeigt sich hierbei, dass das Basismaterials eine entscheidende Komponente des erfindungsgemäßen Substrathalter ist.

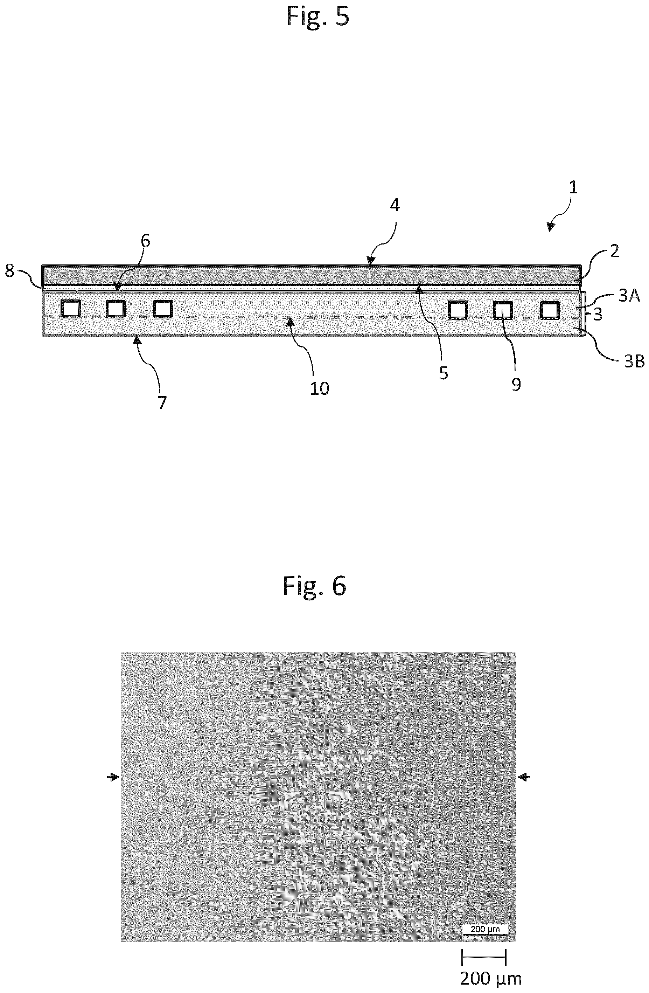

Fig. 5 zeigt eine weitere Ausführungsform des erfindungsgemäßen Substrathalters schematisch im Querschnitt. In dieser Ausführungsform umfasst der erfindungsgemäßen Substrathalters (1) eine Keramikplatte (2) mit einer Oberseite (4) und einer Unterseite (5), wobei die Oberseite (4) als Haltefläche für ein Werkstück (z.B. Silizium-Wafer) ausgebildet ist. Die Basisplatte (3) ist aus zwei Refraktärmetall-basierenden Platten (3A, 3B) aufgebaut, welche durch Diffusionsschweißen verbunden sind (die Fügezone ist durch die gestreichelte schwarze Linie in der Figur angedeutet (10) gekennzeichnet). Eine der Refraktärmetall-basierten Platten (3A) weist Vertiefungen auf, so dass beim Verschweißen mir der zweiten Refraktämetall-basierten Platte (3B) innenliegende Strukturen (9), z.B. Kanäle, zwischen den Refraktärmetall-basierenden Platten (3A, 3B) entstehen. Die Basisplatte weist nach dem Diffusionsschweißen eine Basisplattenoberseite (6) und eine Basisplattenunterseite (7) auf. Über ein Lotmaterial (8) ist die Basisplattenoberseite (6) mit der Keramikplattenunterseite (5) vollflächig verbunden. Die Kanäle (9) können beispielsweise als Kühlmittelkanäle genutzt werden. In vorteilhafter Weise werden so die beiden Refraktärmetall-basierten Platten (3A, 3B) der Basisplatte ohne Zusatzwerkstoffe (wie bspw. Haftvermittler) verbunden. Die hier beschriebene Ausführungsform ist nur beispielshaft und soll in keiner Weise einschränkend für die Anzahl oder Ausformung der Kühlmittelkanäle sein.

Fig. 6 zeigt eine lichtmikroskopische Aufnahme der Basisplatte im Bereich der Diffusionsschweißung. In diesem Beispiel sind beide Refraktärmetall-basierten Platten, welche die Basisplatte ergeben, aus demselben Material hergestellt. Die Verbindungszone zwischen den beiden Platten wird durch die seitlichen Pfeile gekennzeichnet. Es ist keine Übergangszone zu erkennen. Somit liegt eine stoffschlüssige Verbindung nach dem Diffusionsschweißen vor, d.h. die Basisplatte weist die gleichen physikalischen und mechanischen Eigenschaften auf wie die beiden Refraktärmetall-basierten Platten.

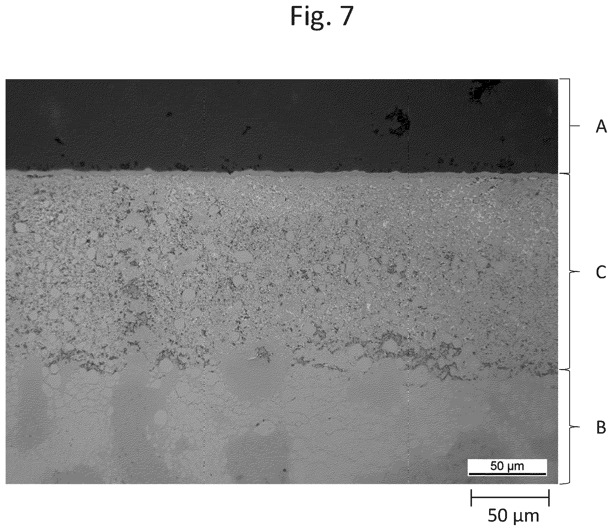

Fig. 7 zeigt einen Querschnitt des erfindungsgemäßen Substrathalters in einer lichtmikroskopischen Aufnahme bei einer 500-fachen Vergrößerung. Die Keramikplatte ist Al₂O₃ mit einer Reinheit von 99,99%, die Lotschicht ist Ticusil^{®} und die Basisplatte ist eine Molybdänbasierte Legierung. Dabei ist die Keramikplatte (A) mit der Basisplatte (B) über das Lotmaterial (C) vollflächig bzw. flächendeckend verbunden.

## Patentansprüche

1. Ein Substrathalter (1) für eine elektrostatische Spannvorrichtung umfassend eine Keramikplatte (2) mit einer Keramikplattenoberseite (4) und einer Keramikplattenunterseite (5), wobei die Keramikplattenoberseite (4) ausgebildet ist, um ein Werkstück zu halten, und
eine Basisplatte (3) mit einer Basisplattenoberseite (6) und einer Basisplattenunterseite (7), wobei die Basisplattenoberseite zumindest abschnittsweise als Auflagefläche zur Verbindung mit der Keramikplattenunterseite ausgebildet ist, und die Auflagefläche eine Ebene ist, die am weitesten in Richtung der Keramikplatte hervorsteht, **dadurch gekennzeichnet, dass** die Basisplattenoberseite (6) im Bereich ihrer Auflagefläche vollflächig mit der Keramikplattenunterseite (5) über ein Lotmaterial (8) verbunden ist, und die Basisplatte aus einer Refraktärmetall-basierten Legierung hergestellt ist.

2. Substrathalter gemäß Anspruch 1, **dadurch gekennzeichnet, dass** die gesamte Basisplattenoberseite als Auflagefläche ausgebildet ist.

3. Substrathalter gemäß Anspruch 1 oder Anspruch 2, **dadurch gekennzeichnet, dass** die Keramikplatte (2) frei von eingebauten Elementen ist.

4. Substrathalter gemäß einem der vorherigen Ansprüche, **dadurch gekennzeichnet, dass** die Keramikplattenoberseite (4) freiliegend ist.

5. Substrathalter gemäß einem der vorherigen Ansprüche, **dadurch gekennzeichnet, dass** das Lotmaterial (8) ein Silber-, Kupfer-, Titan- oder Zirkonium-basiertes Aktivlot ist.

6. Substrathalter gemäß einem der vorherigen Ansprüche, **dadurch gekennzeichnet, dass** die Refraktärmetall-basierte Legierung eine Wolfram-basierte oder eine Molybdänbasierte Legierung ist.

7. Substrathalter gemäß einem der vorherigen Ansprüche, **dadurch gekennzeichnet, dass** die Refraktärmetall-basierte Legierung einen linearen Wärmeausdehnungskoeffizienten von über 5,5*10⁻⁶1/K bei Raumtemperatur aufweist.

8. Substrathalter gemäß einem der vorherigen Ansprüche, **dadurch gekennzeichnet, dass** die Mo-basierten Legierung eine Molybdän-Titan Legierung ist.

9. Substrathalter gemäß einem der vorherigen Ansprüche, **dadurch gekennzeichnet, dass** die Keramikplatte aus einem anorganischen, nichtmetallischen Werkstoff hergestellt ist, ausgewählt aus der Gruppe bestehend aus oxidischer Keramik, nitridischer Keramik, Carbidkeramik oder keramischen Faserverbundwerkstoffe.

10. Substrathalter gemäß einem der vorherigen Ansprüche, **dadurch gekennzeichnet, dass** die Basisplatte aus mindestens zwei diffusionsverschweißten Refraktärmetall-basierenden Platten aufgebaut ist.

11. Substrathalter gemäß Anspruch 10, **dadurch gekennzeichnet, dass** zumindest zwei Platten der Basisplatte aus derselben Refraktärmetall-basierenden Legierung hergestellt sind.

12. Substrathalter gemäß einem der vorherigen Ansprüche, **dadurch gekennzeichnet, dass** die Basisplatte eine innenliegende Struktur aufweist.

13. Substrathalter gemäß einem der vorherigen Ansprüche, **dadurch gekennzeichnet, dass** die Basisplatte bzw. die zumindest zwei Platten der Basisplatte pulvermetallurgisch über Pressen, Sintern und/oder Heißisostatisches Pressen hergestellt sind.

14. Verwendung des Substrathalters gemäß einem der Ansprüche 1 bis 13 in einer elektrostatischen Spannvorrichtung zum Halten und Bearbeiten eines Halbleiter-Wafers.

15. Elektrostatische Spannvorrichtung, umfassend:
einen Substrathalter gemäß einem der Ansprüche 1 bis 13,
Elektrode(n) zur Erzeugung eines elektrostatischen Feldes,
eine Spannungsquelle, um eine elektrische Spannung an die Elektrode(n) anzulegen,
eine Steuerungseinheit, um die Spannung zu überwachen und zu regeln.
